# EUROPEAN PATENT SPECIFICATION

(11) **EP 3 001 405 B1**
(45) Date of publication and mention of the grant of the patent: **20.03.2019**
(21) Application number: 15186395.8
(22) Date of filing: 23.09.2015
(51) Int. Cl.: G09G 3/32

(54) **ORGANIC LIGHT-EMITTING DIODE DISPLAY DEVICE AND METHOD FOR DRIVING THE SAME**
ANZEIGEVORRICHTUNG MIT ORGANISCHEN LICHTEMITTIERENDEN DIODEN UND VERFAHREN ZUR ANSTEUERUNG DAVON
DISPOSITIF À DIODE D'AFFICHAGE ÉLECTROLUMINESCENT ORGANIQUE ET SON PROCÉDÉ DE COMMANDE

(30) Priority: 23.09.2014 KR 20140126856
(43) Date of publication of application: 30.03.2016
(73) Proprietor: LG Display Co., Ltd., SEOUL, 07336 (KR)
(72) Inventor: NOH, So-Young, 410-380 Gyeonggi-do (KR); RYU, Won-Song, 411-320 Gyeonggi-do (KR)
(74) Representative: Ter Meer Steinmeister & Partner

(56) References cited:
- JP-A- 2006 215 275
- US-A1- 2006 028 407
- US-A1- 2006 038 762
- US-A1- 2011 279 356

## Description

This application claims the benefit of Korean Patent Application No. 10-2014-0126856, filed on September 23, 2014.

### Field of the Invention

The present invention relates to an organic light-emitting diode (OLED) display device and, more particularly, to an OLED display device for providing a signal to control a transistor and a power voltage to drive an OLED by using one signal line. Further it relates to a method for driving the same.

### Discussion of the Related Art

In US-2011/2279356-A1 a method of reducing power consumption of an electro-optical display device is described which can display a still image with the use of analog signals. A circuit in with a small amount of leakage current flows between a source and a drain of a selection transistor when the selection transistor is off; the source of the selection transistor is connected to a gate of an N-channel driving transistor, a gate of a P-channel driving transistor, and one electrode of a capacitor. A source of each of the N-channel driving transistor and the P-channel driving transistor is connected to one electrode of the LC display element is provided in each pixel. The LC-element is provided with. A drain of a P-channel driving transistor is connected to a scan line Xn. The selection transistor in each of the electro-optical display devices is an N-channel transistor and the scan line Xn has potential whose value is less than to the minimum value of potential applied to one electrode if the LC display element, and thus is suitable for being connected to the drain of the P-channel driving transistor. To avoid influences, it is necessary that a capacitor is 10 times as high as the gate capacitance of the P-channel driving transistor.

An organic light-emitting diode (OLED) display device is described in JP-2006-215275-A. It is a self-emissive device for emitting light from an organic emission layer using recombination of electrons and holes and is regarded as a next-generation display device due to a high brightness level, a low driving voltage, and an ultra-thin size thereof.

Document US 2006/038762 discloses in its figure 6 an OLED pixel with a data TFT (603) and a driving TFT (601). A scan line of the data TFT (603) is used also to supply power to the driving transistor (601).

Document(US2006/0028407) discloses in its figure 4 an OLED pixel with a data TFT (403) and a driving TFT (401). A scan line of the data TFT (403) is used also to supply power to the driving transistor (401).

Each of a plurality of pixels included in an OLED display device includes an OLED including an organic emission layer between an anode and a cathode and a pixel driving circuit for independently driving the OLED. The pixel driving circuit largely includes a switching thin film transistor (TFT), a capacitor, and a driving TFT. The switching TFT charges a voltage corresponding to a data voltage in the capacitor in response to a scan pulse (or gate pulse), and the driving TFT controls the amount of light emitted from the OLED, by controlling the amount of current applied to the OLED depending on the magnitude of the voltage charged in the capacitor. The amount of light emitted from the OLED is proportional to the current applied from the driving TFT.

However, the conventional OLED display device has various problems because a plurality of signal lines are provided on a display panel and thus spaces for OLEDs and pixel driving circuits are restricted. Specifically, various signal lines such as data lines, reference lines, power lines, and gate lines are provided on the display panel to cross one another, and regions for OLEDs and pixel driving circuits are defined at locations where the signal lines cross one another.

Since a plurality of signal lines are provided on a display panel and thus spaces for OLEDs and pixel driving circuits are restricted, the OLED display device has problems such as a reduction in aperture ratio, a reduction in brightness level due to the reduction in aperture ratio.

Also, since a large amount of current is applied to increase the brightness and to compensate for the small aperture ratio, large power consumption or rapid deterioration of the OLEDs are caused.

In addition, the OLEDs may not be provided in a necessary size due to the lack of space, a sufficient amount of current may not be applied to the OLEDs due to the restriction in size, and thus a desired brightness level may not be achieved.

### SUMMARY OF THE INVENTION

Accordingly, the present invention is directed to an organic light-emitting diode (OLED) display device and a method for driving the same that substantially obviates one or more problems due to limitations and disadvantages of the related art.

An object of the present invention is to provide an OLED display device and a method for driving the same for providing a signal to control a transistor and a power voltage to drive an OLED by using one signal line.

Additional advantages, objects, and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

The object is solved by the features of the independent claims. Preferred embodiments are given in the dependent claims.

To achieve these objects and other advantages and in accordance with the purpose of the invention, as embodied and broadly described herein, an organic light-emitting diode (OLED) display device display device according to the present invention is adapted to apply a scan power signal to a gate line including a scan pulse for turning on a switching thin film transistor (TFT) and a power voltage for allowing an OLED to emit light. If the scan pulse is input, the switching TFT a data voltage is charged in a storage capacitor. If a driving TFT is turned on due to the data voltage charged in the capacitor, the driving TFT provides the power voltage of the scan power signal to the OLED to allow the OLED to emit light.

Preferably, the switching TFT may be configured as a P-type transistor.

Preferably, the scan pulse is a negative (-) voltage, and the power voltage is a positive (+) voltage.

The object is solved by an organic light-emitting diode display device comprising: a data line to which a data voltage is applied; a reference line to which a reference voltage is applied; a first gate line to which a scan signal is applied; a second gate line to which a scan power signal is applied comprising a scan pulse corresponding to a gate-on-voltage for a second switching TFT and a power voltage corresponding to a gate-off-voltage for the second switching TFT; and a pixel comprising an OLED and a pixel driving circuit connected to the data line, the reference line and the first and second gate lines to drive the OLED, wherein the pixel circuit comprises: a first switching TFT turned on based on the scan signal to provide the data voltage to a first electrode of a storage capacitor; the second switching TFT turned on based on the scan pulse of the scan power signal to provide the reference voltage to a second electrode of the storage capacitor; the storage capacitor for charging a difference voltage between the data voltage and the reference voltage and providing the difference voltage to a driving TFT; and the driving TFT for providing the power voltage to the OLED based on the difference voltage to control a current to be provided to the OLED.

Preferably, a gate electrode, a first electrode, and a second electrode of the first switching TFT are connected to the first gate line, the data line, and a first node, respectively,

wherein a gate electrode, a first electrode, and a second electrode of the second switching TFT are connected to the second gate line, the reference line, and a second node, respectively , wherein a gate electrode, a first electrode, and a second electrode of the driving TFT are connected to the first node, the second gate line, and the second node, respectively, and wherein the storage capacitor is connected between the first node and the second node.

Preferably, the second switching TFT may be configured as a P-type transistor.

Preferably, the scan pulse is a negative (-) voltage, and the power voltage is a positive (+) voltage.

The object is also solved by an organic light-emitting diode display device comprising: a data line to which a data voltage is applied; an initialization line to which an initialization voltage is applied; a first gate line to which a scan signal is applied; an emission control line to which an emission control signal is applied; a second gate line to which a scan power signal is applied comprising a scan pulse corresponding to a gate-on-voltage for a second switching TFT, a gate-off-voltage for the second switching TFT, and a power voltage is applied; and a pixel comprising an OLED and a pixel driving circuit connected to the data line, the initialization line, the emission control line, and the first and second gate lines, wherein the pixel driving circuit comprises: a first switching TFT turned on based on the scan signal to provide the data voltage to a first electrode of a storage capacitor; the second switching TFT turned on based on the scan pulse of the scan power signal to provide the initialization voltage to a second electrode of the storage capacitor; a third switching TFT turned on based on the emission control signal to provide the power voltage to a driving TFT; the storage capacitor for charging a difference voltage between the initialization voltage and a voltage obtained by compensating a threshold voltage of the driving TFT in the data voltage and providing the difference voltage to the driving TFT; and the driving TFT for providing the power voltage to the OLED based on the difference voltage to control a current to be provided to the OLED.

Preferably, two neighboring pixels share the second switching TFT.

Preferably, the pixel driving circuit further comprises an auxiliary capacitor connected between the first node and the second gate line.

Preferably, the scan pulse is applied in a first period of the scan power signal, the power voltage is applied in a second period of the scan power signal, and the gate off voltage is applied in a third period of the scan power signal.

Preferably, the second switching TFT may be configured as a P-type transistor.

Preferably, the scan pulse is a negative (-) voltage, and the power voltage is a positive (+) voltage.

Preferably, the high potential power voltage for driving the OLED is provided through one of the gate lines.

Preferably, the gate of the switching TFT and a second electrode of the OLED are connected to the same gate line.

Preferably, the scan power signal includes the scan pulse being a gate-on-voltage of switching TFT being applied in a selection period and power voltage corresponding to a gate-off-voltage for the switching TFT for switching off the switching TFT and for driving the OLED during the emission period.

The object is further solved by a method for driving an organic light-emitting diode display device, comprising the steps of: supplying a scan pulse to a switching TFT during a selective period for switching on the switching TFT; supplying a power voltage via the same line to a driving transistor of the OLED during an emission period, the power voltage corresponding to a gate-off voltage of the switching TFT.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:
FIG. 1 is a schematic diagram of a pixel driving circuit according to a first comparative example not forming part of the present invention;
FIG. 2 is an equivalent circuit diagram of two representative pixels of FIG. 1;
FIG. 3 shows waveforms for driving the OLED display device according to the first comparative example;
FIG. 4 is a circuit diagram of an OLED display device according to a first embodiment of the present invention;
FIG. 5 shows waveforms of driving signals for driving the OLED display device of FIG. 4 according to the first embodiment;
FIG. 6 is a circuit diagram of an OLED display device according to a second embodiment of the present invention; and
FIG. 7 shows waveforms of driving signals for driving the OLED display device of FIG. 6.

### DETAILED DESCRIPTION OF THE INVENTION

Hereinafter, the present invention will be described in detail by explaining embodiments of the invention with reference to the attached drawings. Like reference numerals in the drawings denote like elements. In the following description of the present invention, a detailed description of known functions and configurations incorporated herein will be omitted when it may make the subject matter of the present invention unclear. It will be easily understood by one of ordinary skill in the art that some elements of the drawings are exaggerated, reduced, or schematically illustrated for convenience of description and are not always illustrated with appropriate ratios thereof.

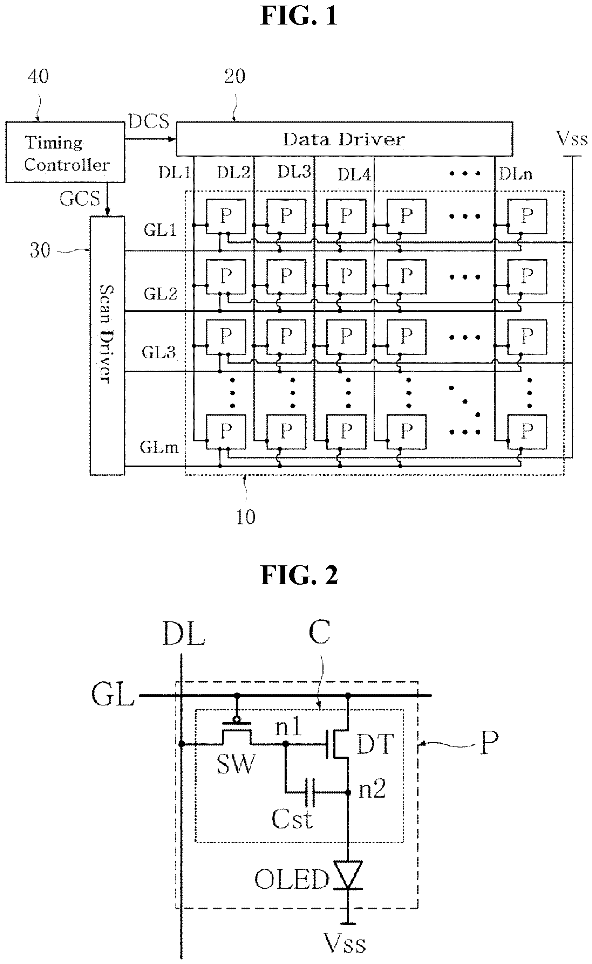

FIG. 1 is a schematic diagram of a pixel driving circuit according to a first comparative example not forming part of the present invention, and FIG. 2 is an equivalent circuit diagram of two representative pixels of FIG. 1.

Referring to FIG. 1, an organic light-emitting diode (OLED) display device is configured to include data lines DL: DL1 to DLn (where n is a natural number) provided along a first direction of a display panel 10, gate lines GL: GL1 to GLm (where m is a natural number) provided in a vertical direction to the data lines DL, and pixels P in pixel regions defined at locations where the gate lines GL and the data lines DL cross each other. Each of pixels includes an OLED and a pixel driving circuit for independently driving the OLED.

The OLED display device according to the first comparative example not forming part of the present invention uses the gate lines GL as high-potential power lines or low-potential power lines configured to drive OLEDs, and thus additional power lines are not necessary. Specifically, according to the first comparative example, the high-potential power lines are omitted and the pixel driving circuits are used therefor. That is, according to the conventional technology, a high-potential power line is provided at each pixel regions. However, according to the present invention, only the data lines DL and the gate lines GL are provided between pixels P. In addition, according to the first comparative example, low-potential power lines (not illustrated in FIG. 1) are connected to cathodes of the OLEDs, but high-potential power lines are not necessary.

The above-described OLED display device is configured to include a display panel 10, a data driver 20, a scan driver (or gate driver) 30, and a timing controller 40, and to further include a gamma voltage generator (not shown) and a data processor (not shown).

The timing controller 40 generates and outputs a data control signal DCS and a gate control signal GCS for driving timings of the data driver 20 and the scan driver 30, respectively. Here, the data processor may apply a predetermined compensation value to data input from the outside, and output the compensated input data to the timing controller 40. In addition, the timing controller 40 may determine a peak brightness level based on an average picture level (APL) of the input data and provide the same to the gamma voltage generator, and the gamma voltage generator may generate a gamma voltage set including a plurality of gamma voltages having different levels and provide the same to the data driver 20.

The data driver 20 converts digital data received from the timing controller 40 into analog data voltages and provides the same to the data lines DL of the display panel 10 in response to the data control signal DCS received from the timing controller 40. In this case, a data provider of the data driver 20 subdivides the gamma voltage set received from the gamma voltage generator into gradation voltages individually corresponding to gradation values of data, and then converts the digital data into the analog data voltages using the subdivided gradation voltages. The data driver 20 provides the converted analog data voltages to pixels selected by a scan pulse.

The scan driver 30 sequentially drives the gate lines GL of the display panel 10 in response to the gate control signal GCS received from the timing controller 40. The scan driver 30 provides a scan power signal to each gate line GL in response to the gate control signal GCS. Specifically, the scan driver 30 provides a scan pulse corresponding to a gate on voltage in a gate period of each gate line GL, and provides a high-potential power voltage for driving the OLED as a gate off voltage to the gate lines GL in the other period. As such, each gate line GL provides the scan pulse corresponding to the gate on voltage for controlling driving of a switching thin film transistor (TFT) of the pixel driving circuit in a horizontal cycle for selecting a pixel to receive data input, i.e., a selection period (Se1), and provides the power voltage to the gate lines GL as the gate off voltage in a non-selection period (or emitting period) E1.

The display panel 10 includes a plurality of pixels P. Each pixel P may be a red (R), green (G), or blue (B) pixel or a red (R), green (G), blue (B), or white (W) pixel. However, the colors of the pixels are not limited thereto and are variable. The pixels P are selected due to scan power signals sequentially provided from the scan driver 30 on a line basis as described above, and are charged with analog data voltages Vdata provided from the data driver 20 in the selection period to emit light in an emission period. Specifically, each pixel is selected due to a scan pulse of the scan power signal provided from the scan driver 30 in the selection period Se1, is charged with the data voltage Vdata, and provides the power voltage corresponding to the gate off voltage of the scan power signal, which is provided in the emitting period E1, to an OLED due to the charged data voltage, thereby emitting light.

To this end, each pixel is configured to include a pixel driving circuit C and an OLED as illustrated in FIG. 2, and the pixel driving circuit C is configured to include a driving TFT DT, a switching TFT SW1, and a storage capacitor Cst.

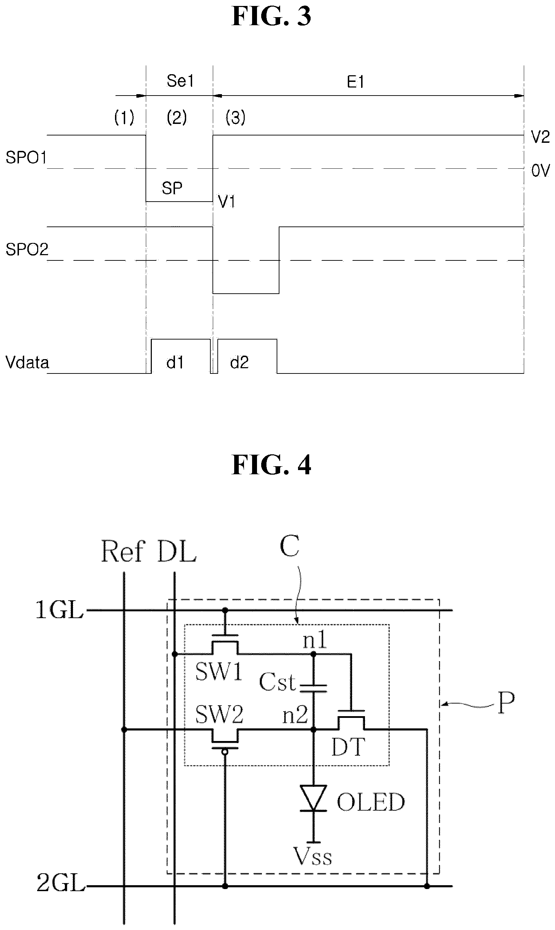

The switching TFT SW1 includes a gate electrode connected to the gate line GL, a first electrode connected to the data line DL, and a second electrode connected to a first node n1. If a scan pulse of a scan power signal is applied to the gate line GL in the selection period, the switching TFT SW1 is turned on due to a gate on voltage of the scan pulse and charges the data voltage Vdata provided through the data line DL in the first node n1. A detailed description of the switching TFT driving method will be given below with reference to FIG. 3. Particularly, the switching TFT SW1 is configured as a TFT which is turned off due to a gate off voltage included in the scan power signal. Specifically, the switching TFT SW1 may be configured as a P-type transistor. That is, by configuring the switching TFT SW1 as a P-type TFT, a negative voltage may be used as the gate on voltage and a positive first voltage VDD for driving the OLED may also be used as the gate off voltage.

The storage capacitor Cst includes a first electrode connected to a gate electrode of the driving TFT DT corresponding to the first node n1, and a second electrode connected to a first electrode of the OLED corresponding to a second node n2. The first comparative example will be described on the assumption that the first electrode of the OLED is an anode electrode. The storage capacitor Cst is charged with the data voltage Vdata provided by the switching TFT SW1 in the selection period, and provides the same as a driving voltage Vgs of the driving TFT DT in the non-selection period corresponding to the emission period.

The driving TFT DT includes a gate electrode connected to the first node n1, a first electrode connected to the second node n2, and a second electrode connected to the gate line GL. In this case, the gate line GL connected to the second electrode of the driving TFT DT may be different from the gate line GL connected to the gate electrode of the switching TFT SW1 included in the same pixel driving circuit. However, the present comparative example will be described on the assumption that the second electrode of the driving TFT DT and the gate electrode of the switching TFT SW1 are connected to the same gate line. In addition, the first electrode and the second electrode of the driving TFT DT serve as a source electrode and a drain electrode depending on a current direction. The driving TFT DT provides a current proportional to the driving voltage Vgs provided from the storage capacitor Cst, through the second node n2 to the OLED to allow the OLED to emit light in the non-selection period corresponding to the emission period. To this end, the driving TFT DT is turned on, receives the gate off voltage provided through the gate line GL, and provides the current to the OLED in the emission period.

The OLED is connected in series with the driving TFT DT between the gate line GL and a second power line VSS. The OLED includes an anode, e.g., a first electrode, connected to the driving TFT DT, a cathode connected to the second power line VSS, and an emission layer provided between the anode and the cathode. The emission layer includes an electron injection layer, an electron transport layer, an organic emission layer, a hole transport layer, and a hole injection layer, which are sequentially stacked on one another between the cathode and the anode. In the OLED, if a positive bias is applied between the anode and the cathode, electrons are provided from the cathode through the electron injection layer and the electron transport layer to the organic emission layer, and holes are provided from the anode through the hole injection layer and the hole transport layer to the organic emission layer. As such, due to recombination of the provided electrons and holes in the organic emission layer, a fluorescent or phosphor material emits light proportional to the amount of current.

As described above, the OLED display device according to the first embodiment of the present invention provides a high-potential power voltage for driving OLEDs through gate lines. As such, by providing a power voltage through the gate lines without configuring additional power lines, a space for the power lines may be utilized for another purpose.

Particularly, in the above-described OLED display device according to the first comparative example, to allow the high-potential power voltage to be provided through the gate lines, the high-potential power voltage provides different negative voltages as a scan pulse, and a P-type TFT which is turned on due to the scan pulse is used as a switching TFT. Although a P-type TFT is used as the switching TFT according to the first comparative example, an N-type TFT may be used to configure the switching TFT, the scan pulse may be provided as a positive voltage, a gate off voltage and a data voltage may be provided as negative voltages, and the driving TFT DT may be configured using a P-type TFT. However, in this configuration, conventional signals need to be converted to opposite polarities and the positions of the anode and cathode of the OLED need to be changed.

FIG. 3 shows waveforms for driving the OLED display device according to the first comparative example.

Referring to FIG. 3, the OLED display device according to the first comparative example provides the scan power signal through the gate line GL, and thus controls on/off state of the switching TFT SW1 and provides a power voltage for driving the OLED at the same time.

To this end, as illustrated in FIG. 3, the scan power signal includes a scan pulse SP corresponding to a gate on voltage V1 of the first switching TFT SW1, and a gate off voltage V2 corresponding to a driving power voltage. The scan pulse SP is shifted every horizontal cycle 1H and applied sequentially to the gate lines GL, and the gate off voltage V2 is applied to each gate line GL in a period in which the scan pulse SP is not applied.

Specifically, the scan pulse SP and the gate off voltage V2 are applied to each gate line GL in the selection period and the emission period, respectively. The selection period is given as a time period equal to or shorter than the horizontal cycle 1H, and the scan driver 30 provides the scan pulse SP to the gate line GL in the selection period. The OLED display device emits light in the emission period subsequent to a frame of the selection period.

A description is now given of operation of the pixel P of FIG. 2 due to the scan power signal applied to the first gate line GL1. The gate off voltage V2 corresponding to a positive voltage is provided to the first gate line GL1 in period 1). As such, the first switching TFT SW1 configured as a P-type TFT is maintained in off state due to the gate off voltage V2 corresponding to a positive voltage.

In period 2) corresponding to the selection period, the scan pulse SP corresponding to the negative gate on voltage V1 is applied to the first gate line GL1, and the first switching TFT SW1 is turned on due to the scan pulse SP. In this case, if a first data voltage D1 is provided through the data line DL, the first data voltage D1 is provided to the first node n1 by the turned-on first switching TFT SW1 and thus is charged in the storage capacitor Cst.

In period 3) corresponding to the emission period, the positive gate off voltage V2 is provided to the first gate line GL1 again and the first switching TFT SW1 is turned off. The driving TFT DT is turned on due to the first data voltage D1 charged in the storage capacitor Cst. As the driving TFT DT is turned on, the first gate line GL1 serves as a conventional first power line due to the gate off voltage V2 provided through the first gate line GL1 and the driving TFT DT provides a current required to drive the OLED, to the OLED.

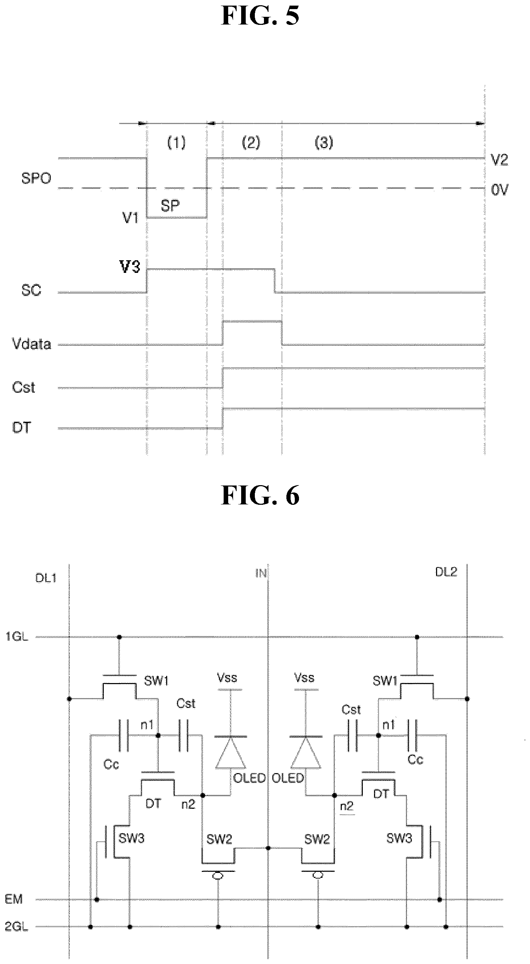

FIG. 4 is a circuit diagram of an OLED display device according to a first embodiment of the present invention. FIG. 5 shows waveforms of driving signals for driving the OLED display device of FIG. 4 according to the first embodiment.

Referring to FIG. 4, compared to the above-described first comparative example, the OLED display device according to the first embodiment of the present invention further ineludes a reference line Ref for detecting and compensating a threshold voltage Vth of the driving TFT DT, a second switching TFT SW2 connected to the reference line Ref, and a second gate line 2GL for controlling on/off state of the second switching TFT SW2 and providing a power voltage for driving an OLED to emit light. Here, although a scan pulse SP and a power voltage may be provided through a first gate line 1GL connected to a gate electrode of the first switching TFT SW1, the first embodiment will be described on the assumption that the scan pulse and the power voltage are provided to the second gate line 2GL.

The OLED display device according to the first embodiment of the present invention is configured to include the OLED and a pixel driving circuit C, and the pixel driving circuit C is configured to include the driving TFT DT, the first switching TFT SW1, the second switching TFT SW2, and the storage capacitor Cst. The display panel 10 includes the data line DL, the first gate line 1GL, the second gate line 2GL, and the reference line Ref. As illustrated in FIG. 4, the first gate line 1GL and the second gate line 2GL may be provided in parallel to each other by disposing a pixel therebetween, and the data line DL and the reference line Ref may be provided in parallel to each other. In addition to the illustrated form, the location and arrangement of the lines may be changed in various ways. The following description is focused on new or different features compared to the above-described first comparative example.

The first switching TFT SW1 includes a gate electrode connected to the first gate line 1GL, a first electrode connected to the data line DL, and a second electrode connected to the first node n1. The first switching TFT SW1 is turned on or off due to a scan signal provided through the first gate line 1GL and provides a data voltage Vdata provided through the data line DL, to the first node n1.

The second switching TFT SW2 includes a gate electrode connected to the second gate line 2GL, a first electrode connected to the reference line Ref, and a second electrode connected to the second node n2. The second switching TFT SW2 receives a scan power signal SPO provided through the second gate line 2GL and provides a reference voltage Vref received from the reference line Ref, to the second node n2. Specifically, if a scan pulse of the scan power signal is applied to the second gate line 2GL, the second switching TFT SW2 is turned on due to a gate on voltage of the scan pulse and provides the reference voltage Vref received through the reference line Ref, to the second node n2 to initialize the second node n2. Here, the scan power signal provided to the second gate line 2GL includes the gate on voltage corresponding to a negative (-) voltage, and the first power voltage corresponding to a positive (+) gate off voltage. The second switching TFT SW2 is configured as a P-type transistor turned on due to the gate on voltage of the scan power signal. That is, a negative voltage may be used as the gate on voltage by configuring the second switching TFT SW2 as a P-type TFT, and the positive voltage VDD for driving the OLED may also be used as the gate off voltage. As such, a scan pulse for driving the second switching TFT SW2 and a power voltage may be simultaneously provided through the second gate line 2GL.

The storage capacitor Cst includes a first electrode connected to a gate electrode of the driving TFT DT corresponding to the first node n1, and a second electrode connected to the second node n2. After the second electrode of the storage capacitor Cst connected to the second node n2 is initialized due to the reference voltage Vref provided from the second switching TFT SW2, the storage capacitor Cst receives the data voltage Vdata from the first switching TFT SW1 and is charged with a difference voltage between the data voltage Vdata and the reference voltage Vref. The storage capacitor Cst provides the charged difference voltage to the driving TFT DT as the driving voltage Vgs in the emission period.

The driving TFT DT includes a gate electrode connected to the first node n1, a first electrode connected to the second node n2, and a second electrode connected to the second gate line 2GL. The first electrode and the second electrode of the driving TFT DT serve as a source electrode and a drain electrode depending on a current direction. The driving TFT DT is turned on due to the driving voltage Vgs provided from the storage capacitor Cst and provides a current for driving the OLED using the first power voltage provided through the second gate line 2GL.

Referring to FIG. 5, unlike the above-described first comparative example, the OLED display device according to the first embodiment of the present invention is configured to include a pair of the first and second gate lines 1GL and 2GL configured as the gate line GL, and the first and second switching TFTs SW1 and SW2 driven due to scan signals provided through the first and second gate lines 1GL and 2GL, respectively. In particular, according to the first embodiment, the scan power signal is provided through the second gate line 2GL, and thus on/off state of the second switching TFT SW2 is controlled and a power voltage for driving the OLED is provided at the same time.

To this end, a scan power signal SPO, a scan signal SC, and a data voltage Vdata provided to one pixel are shown in FIG. 5. In addition, FIG. 5 also shows a charge period of the storage capacitor Cst and on/off periods of the driving TFT DT.

As illustrated in FIG. 5, the scan power signal SPO includes the scan pulse SP corresponding to the gate on voltage V1 of the second switching TFT SW2 and the gate off voltage V2 corresponding to a driving power voltage. The scan pulse SP is shifted every horizontal cycle 1H and applied sequentially to the second gate lines 2GL, and the gate off voltage V2 is applied to each second gate line 2GL in a period in which the scan pulse SP is not applied.

Specifically, signals applied to the first and second gate lines 1GL and 2GL may differ based on a non-emission period and an emission period, and the emission period may be divided into a selection period and the emission period.

In the non-emission period, as illustrated in FIG. 5, the scan pulse SP of the gate on voltage V1 is applied to the second gate line 2GL and thus the second switching TFT SW2 is turned on, a reference voltage provided through the reference line Ref is provided to the second node n2 by the turned-on second switching TFT SW2.

Meanwhile, in the non-emission period, the scan signal SC of the gate on voltage V3 is also applied to the first gate line 1GL. The first switching TFT SW1 is also turned on due to the scan signal SC of the gate on voltage V3 applied to the first gate line 1GL, but only serves to stabilize the voltage of the first node n1 because a data voltage is not applied.

In the selection period of the emission period, the first power voltage corresponding to a gate off voltage V2 is applied to the second gate line 2GL and thus the second switching TFT SW2 is turned off, and the scan signal SC of the gate on voltage is continuously applied to the first gate line 1GL and thus the first switching TFT SW1 is maintained in on state. In this case, the data voltage Vdata is applied through the data line DL and charged in the storage capacitor Cst through the first switching TFT SW1, and the OLED starts to emit light.

In the emission period, the power voltage corresponding to the gate off voltage V2 is continuously applied to the second gate line 2GL, and a gate off voltage of the scan signal SC is applied to the first gate line 1GL. In this emission period, a difference voltage between the data voltage Vdata charged in the storage capacitor Cst and the reference voltage Vref is provided to the driving TFT DT to turn on the driving TFT DT, and a current due to the power voltage corresponding to a gate off voltage V2 is provided to the OLED and thus the OLED emits light during the on period of the driving TFT DT.

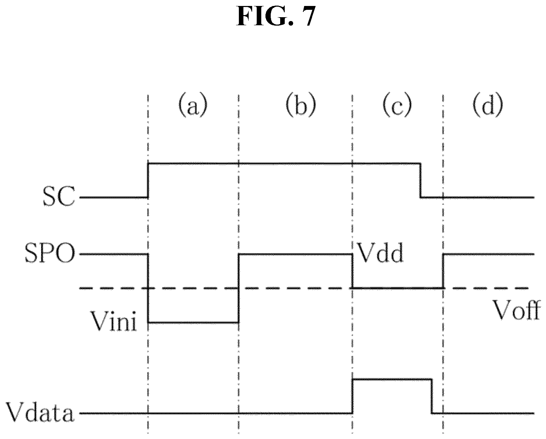

FIG. 6 is a circuit diagram of an OLED display device according to a second embodiment of the present invention. FIG. 7 shows waveforms of driving signals for driving the OLED display device of FIG. 6.

Referring to FIG. 6, the OLED display device according to the second embodiment of the present invention is configured to include data lines DL, an initialization line IN provided in parallel to the data lines DL, first and second gate lines 1GL and 2GL provided to cross the data lines DL, an emission control line EM provided in parallel to the first and second gate lines 1GL and 2GL, and a pixel in a pixel region defined at a location where the data lines DL and the first and second gate lines 1GL and 2GL cross each other. Each of pixels includes an OLED and a pixel driving circuit for independently driving the OLED.

In the OLED display device according to the second embodiment of the present invention, the second gate line 2GL is used to provide a scan power signal for driving control of the second switching TFT SW2, and to provide the power voltage for emission of an OLED.

The pixel of the OLED display device according to the second embodiment of the present invention is configured to include first to third switching TFTs SW1, SW2, and SW3, a driving TFT DT, a storage capacitor Cst, and an auxiliary capacitor Cc.

The first switching TFT SW1 includes a gate electrode connected to the first gate line 1GL, a first electrode connected to the data line DL1, and a second electrode connected to a first node n1. The first switching TFT SW1 is turned on due to a scan signal SC provided through the first gate line 1GL and thus provides a data voltage received through the data line DL1, to the first node n1.

The second switching TFT SW2 includes a gate electrode connected to the second gate line 2GL, a first electrode connected to the initialization line IN, and a second electrode connected to a second node n2. The second switching TFT SW2 receives a scan power signal SPO through the second gate line 2GL and provides an initialization voltage Vini received through the initialization line IN, to the second node n2. Specifically, if a scan pulse SP of the scan power signal SPO is provided to the second gate line 2GL, the second switching TFT SW2 is turned on due to a gate on voltage of the scan pulse SP and provides the initialization voltage Vini received through initialization line IN to the second node n2 to initialize the second node n2. To this end, the second switching TFT SW2 is configured as a P-type TFT which is turned on due to a negative gate on voltage. Here, the scan power signal SPO provided to the second gate line 2GL includes the gate on voltage corresponding to a negative (-) voltage, a power voltage Vdd corresponding to a positive (+) gate off voltage, and an off voltage Voff. A detailed description of the scan power signal SPO and driving using the same will be given below with reference to FIG. 7. Here, the second switching TFT SW2 may be configured in such a manner that the initialization line IN is shared by a pair of pixels as illustrated in FIG. 6. However, the present invention is not limited thereto.

The third switching TFT SW3 includes a gate electrode connected to the emission control line EM, a first electrode connected to the second gate line 2GL, and a second electrode connected to a first electrode of the driving TFT DT. The third switching TFT SW3 is turned on or off due to an emission control signal provided through the emission control line EM and provides the first voltage Vdd applied through the second gate line 2GL to the driving TFT DT. The emission control signal provided through the emission control line EM may be a signal equal to the scan power signal SPO, or a signal including only the first voltage Vdd and the off voltage Voff of the scan power signal SPO.

The storage capacitor Cst includes a first electrode connected to a gate electrode of the driving TFT DT corresponding to the first node n1, and a second electrode connected to the second node n2. In the storage capacitor Cst, the second electrode connected to the second node n2 is initialized due to the initialization voltage Vini provided by the second switching TFT SW2, and a difference voltage between the initialization voltage Vini and a threshold voltage Vth of the driving TFT DT, which is detected due to the first voltage Vdd applied to the first electrode of the the driving TFT DT, is charged in the third switching TFT SW3 which is turned on in a sampling period. The storage capacitor Cst is charged with a difference voltage (Vdata+Vth-Vini) between the initialization voltage Vini and a voltage obtained by compensating the threshold voltage Vth in the data voltage Vdata provided to the first node n1 by the first switching TFT SW1 in a charge period. In an emission period, the storage capacitor Cst provides the difference voltage (Vdata+Vth-Vini) charged in the charge period, to the driving TFT DT to turn on the driving TFT DT, thereby allowing the OLED to emit light.

The auxiliary capacitor Cc includes a first electrode connected to the first node n1, and a second electrode connected to the second gate line 2GL. The auxiliary capacitor Cc may be charged with the data voltage Vdata together with the storage capacitor Cst to provide insufficient capacity of the storage capacitor Cst and to achieve fast and stable charge.

The driving TFT DT includes a gate electrode connected to the first node n1, a first electrode connected to the second electrode of the third switching TFT SW3, and a second electrode connected to the second node n2. The driving TFT DT is turned on due to the voltage charged in the storage capacitor Cst and the auxiliary capacitor Cc in the emission period to provide a current due to the first voltage Vdd provided by the third switching TFT SW3, to the OLED, thereby allowing the OLED to emit light.

Referring to FIG. 7, the OLED display device according to the second embodiment provides the scan power signal SPO for driving control of the second switching TFT SW2 and provides a power voltage for emission of an OLED, using the second gate line 2GL.

Specifically, a scan signal SC, a scan power signal SPO, and a data voltage Vdata are separately provided to the pixel circuit in an initialization period (a), a sampling period (b), a charge period (c), and an emission period (d). Here, FIG. 7 assumes that the scan power signal SPO applied to the second gate line 2GL is also applied to the emission control line EM. However, signals provided to the emission control line EM may apply the first voltage Vdd corresponding to a positive voltage in the sampling period (b) and the emission period (d) and apply the off voltage Voff in the charge period (c).

In the initialization period (a), the scan signal SC of a gate on voltage is applied to the first gate line 1GL and a negative gate on voltage of the scan power signal SPO is applied to the second gate line 2GL and the emission control line EM. As the scan signal SC of the gate on voltage is applied to the first gate line 1GL, the first switching TFT SW1 is turned on and the reference voltage Vref applied to the data line DL is provided to the first node n1 during a data voltage is not applied. In addition, the third switching TFT SW3 is maintained in off state due to the negative gate on voltage applied to the second gate line 2GL and the emission control line EM, and the second switching TFT SW2 is turned on and provides the initialization voltage Vini received through the initialization line IN, to the second node n2 to initialize the second node n2.

In the sampling period (b), the scan signal SC provided to the first gate line 1GL is maintained in the gate on voltage and the first voltage Vdd corresponding to a positive power voltage is applied to the second gate line 2GL and the emission control line EM. As such, the first switching TFT SW1 is maintained in on state and thus the reference voltage Vref is provided to the first node n1. As the positive first voltage Vdd is applied to the emission control line EM and the second gate line 2GL, the second switching TFT SW2 is turned off and the third switching TFT SW3 is turned on. As such, the third switching TFT SW3 provides the first voltage VDD to the first electrode of the driving TFT, and the storage capacitor Cst is charged with a voltage corresponding to the threshold voltage of the driving TFT DT in coupling with the first voltage.

In the charge period (c), the scan signal SC provided to the first gate line 1GL is maintained with the gate on voltage, the off voltage Voff is provided to the second gate line 2GL and the emission control line EM, and the data voltage Vdata is provided through the data line DL. As such, the storage capacitor Cst is charged with the data voltage Vdata in which the precharged threshold voltage is compensated.

In the emission period (d), a gate off voltage Voff is applied to the first gate line 1GL and the first voltage Vdd is applied to the second gate line 2GL and the emission control line EM. As such, the driving TFT DT is turned on due to the voltage charged in the storage capacitor Cst and the auxiliary capacitor Cc, and provides a current due to the first voltage Vdd provided by the third switching TFT SW3, to the OLED, thereby allowing the OLED to emit light.

As described above in relation to the first and the second embodiments of present invention, a scan signal for turning on a switching TFT and a power voltage for driving an OLED are simultaneously provided to the switching TFT and a control line connected to the switching TFT. To this end, the switching TFT is configured as a TFT which is turned on due to a voltage having an opposite polarity to the power voltage, and thus may be driven due to a gate on voltage having an opposite polarity to the power voltage for turning on the OLED.

According to the present invention, since a power line for providing a driving power voltage is omitted by providing a signal and the power voltage using a single line, and thus a space for the power line is not necessary, an aperture ratio and a brightness level may be improved, a space for a pixel circuit may be easily ensured, and production costs may be reduced.

Also, since the aperture ratio and the brightness level are improved, a large amount of current to increase the brightness and to compensate for the small aperture ratio is not necessary, the power consumption is decreased and the rapid deterioration of the OLEDs is prevented.

In an OLED display device according to the present invention, since the space for a pixel circuit is easily ensured, the sufficient amount of current may be applied to the OLEDs, and the degree of freedom in design may be increased.

In addition, since a transistor using a signal provided through a single line, as a control signal, and a transistor using the same as a power voltage are configured as opposite types, the signal and the power voltage may be provided using a single line in a simple circuit configuration.

It will be apparent to those skilled in the art that various modifications and variations can be made in the present invention without departing from the scope of the claims. Thus, it is intended that the present invention covers the modifications and variations of this invention provided they come within the scope of the appended claims.

## Claims

1. An organic light-emitting diode, OLED, display device comprising:
a plurality of gate lines (GL) and a plurality of data lines (DL) crossing each other to define a plurality of pixels (P), wherein the plurality of gate lines (GL) includes a first gate line (1GL) to which a scan signal (SC) is applied and a second gate line (2GL) to which a scan power signal (SPO) is applied, and the plurality of data lines (DL) includes a data line adapted to receive a data voltage; wherein the display device further comprises
a reference line (Ref) to which a reference voltage (Vref) is applied;
wherein a pixel (P) includes:
an OLED and a pixel driving circuit (C) for independently driving the OLED of the pixel (P), wherein the pixel driving circuit (C) is connected to the data line (DL), the reference line (Ref), and the first and second gate lines (1GL, 2GL) to drive the OLED;
wherein the pixel driving circuit (C) comprises a first switching TFT (SW1), a second switching TFT (SW2), a storage capacitor (Cst), and a driving TFT (DT),
wherein the first switching TFT (SW1) is turned on based on the scan signal (SC) to provide the data voltage to a first electrode of the storage capacitor (Cst),
wherein the second switching TFT (SW2) of a P type is turned on based on a scan pulse (SP) of the scan power signal (SPO) to provide the reference voltage (Vref) to a second electrode of the storage capacitor (Cst), the scan power signal (SPO) comprising the scan pulse (SP) corresponding to a gate-on-voltage for the second switching TFT (SW2) and a power voltage corresponding to a gate-off-voltage for the second switching TFT (SW2),
wherein the storage capacitor (Cst) is for charging a difference voltage between the data voltage and the reference voltage (Vref) and for providing the difference voltage to the driving TFT (DT); and
wherein the driving TFT (DT) is for providing the power voltage to the OLED based on the difference voltage to control a current to be provided to the OLED;
wherein a gate electrode, a first electrode, and a second electrode of the first switching TFT (SW1) are connected to the first gate line (1GL), the data line (DL), and a first node (n1), respectively,
wherein a gate electrode, a first electrode, and a second electrode of the second switching TFT (SW2) are connected to the second gate line (GL2), the reference line (Ref), and a second node (n2), respectively,
wherein a gate electrode, a first electrode, and a second electrode of the driving TFT (DT) are connected to the first node (n1), the second gate line (2GL), and the second node (n2), respectively, and
wherein the storage capacitor (Cst) is connected between the first node (n1) and the second node (n2);
wherein the OLED has an anode connected to the second node (n2) and a cathode connected to a low-potential power line (Vss)

2. The OLED display device according to claim 1, wherein the scan pulse (SP) is a negative (-) voltage, and the power voltage is a positive (+) voltage.

3. The OLED display device according to any one of the proceedings claims, wherein the second gate line (2GL) is a single line to which the scan power signal (SPO) comprising the scan pulse (SP) corresponding to a gate-on-voltage for the second switching TFT (SW2) and the power voltage corresponding to a gate-off-voltage for the second switching TFT (SW2) is applied.

4. An organic light-emitting diode, OLED, display device comprising:
a plurality of gate lines (GL) and a plurality of data lines (DL) crossing each other to define a plurality of pixels (P), wherein the plurality of gate lines (GL) includes a first gate line (1GL) to which a scan signal (SC) is applied and a second gate line (2GL) to which a scan power signal (SPO) is applied, and the plurality of data lines (DL) includes a data line adapted to receive a data voltage; wherein the display device further comprises:
an initialization line (IN) to which an initialization voltage Vini is applied;
an emission control line (EM) to which an emission control signal is applied;
wherein a pixel (P) includes:
an OLED and a pixel driving circuit (C) for independently driving the OLED of the pixel (P), wherein the pixel driving circuit (C) is connected to the data line (DL), the initialization line (IN), the emission control line (EM), and the first and second gate lines (GL1, GL2) to drive the OLED,
wherein the pixel driving circuit (C) comprises a first switching TFT (SW1), a second switching TFT (SW2), a third switching TFT (SW3), a storage capacitor (Cst), and a driving TFT (DT)
wherein the first switching TFT (SW1) is turned on based on the scan signal (SC) to provide the data voltage to a first electrode of a storage capacitor (Cst);
the second switching TFT (SW2) of a P type is turned on based on a scan pulse (SP) of the scan power signal (SPO) to provide the initialization voltage (Vini) to a second electrode of the storage capacitor, the scan power signal (SPO) comprising the scan pulse (SP) corresponding to a gate-on-voltage for the second switching TFT (SW2) and a power voltage corresponding to a gate-off-voltage for the second switching TFT (SW2);
wherein the third switching TFT (SW3) is turned on based on the emission control signal to provide the power voltage to the driving TFT (DT);
wherein the storage capacitor (Cst) is for charging a difference voltage between the initialization voltage (Vini) and a voltage obtained by compensating a threshold voltage of the driving TFT (DT) in the data voltage and for providing the difference voltage to the driving TFT (DT); and
wherein the driving TFT (DT) is for providing the power voltage to the OLED based on the difference voltage to control a current to be provided to the OLED;
wherein a gate electrode, a first electrode, and a second electrode of the first switching TFT (SW1) are connected to the first gate line (1GL), the data line (DL), and a first node (n1), respectively,
wherein a gate electrode, a first electrode, and a second electrode of the second switching TFT (SW2) are connected to the second gate line (GL2), the initialization line (IN), and a second node (n2), respectively,
wherein a gate electrode, a first electrode, and a second electrode of the third switching TFT (SW3) are connected to the emission line (EM), the second gate line (2GL), and a first electrode of the driving transistor (DT), respectively,
wherein a gate electrode, the first electrode, and a second electrode of the driving TFT (DT) are connected to the first node (n1), the second electrode of the third switching TFT (SW3) (2GL), and the second node (n2), respectively, and
wherein the storage capacitor (Cst) is connected between the first node (n1) and the second node (n2); and
wherein the OLED has an anode connected to the second node (n2) and a cathode connected to a low-potential power line (Vss).

5. The OLED display device according to claim 4, wherein two neighboring pixels (P) share the share the initialization line (IN).

6. The OLED display device according to claim 4 or 5, wherein the pixel driving circuit (C) further comprises an auxiliary capacitor (Cc) connected between the first node (n1) and the second gate line (GL2).

7. The OLED display device according to any one of the claims 4 to 6, wherein the scan pulse (SP) is applied in a first period (a) of the scan power signal (SPO), the power voltage is applied in a second period (b) of the scan power signal (SPO), and a gate off voltage (Voff) is applied in a third period (c) of the scan power signal (SPO).

8. The OLED display device according to any one of the claims 4-7, wherein the scan pulse (SP) is a negative (-) voltage, and the power voltage is a positive (+) voltage.

9. The OLED display device according to any one of the preceding claims, wherein the power voltage is a high potential power voltage for driving the OLED.

10. The OLED display device according to any one of the preceding claims, wherein the scan pulse (SP) is applied in a selection period (SE1) and the power voltage is for driving the OLED during the emission period (E1).

11. Method for driving the organic light-emitting diode, OLED, display device of claim 1, comprising the steps of:
supplying the scan pulse (SP) via the second gate line (2GL) to the second switching TFT (SW2) during a non-emission period (1) for switching on the second switching TFT (SW2);
supplying the power voltage via the same second gate line (2GL) to the driving TFT (DT) of the OLED during an emission period (2, 3), the power voltage corresponding to a gate-off voltage of the second switching TFT (SW2).

12. Method for driving the organic light-emitting diode, OLED, display device of claim 4, comprising the steps of:
supplying the scan signal (SC) via the first gate line (1GL) to the first switching TFT (SW1) and supplying a negative gate-on voltage of the scan power signal (SPO) via the second gate line (2GL) to the second switching TFT (SW2) and via the emission control line (EM) to the third switching TFT (SW3) in an initialization period (a);
maintaining the scan signal (SC) via the first gate line (1GL) to the first switching TFT (SW1) and supplying the power voltage via the same second gate line (2GL) and via the same emission control line (EM) in a sampling period (b)
maintaining the scan signal (SC) via the first gate line (1GL) to the first switching TFT (SW1) and supplying a gate-off voltage (Voff) via the same second gate line (2GL) and via the same emission control line (EM) in a charge period (c)
supplying the gate-off voltage (Voff) via the first gate line (1GL) to the first switching TFT (SW1) and supplying the power voltage via the same second gate line (2GL) and via the same emission control line (EM) in an emission period (d).

## Patentansprüche

1. Anzeigevorrichtung mit organischen lichtemittierenden Dioden, OLED, umfassend:
mehrere Gateleitungen (GL) und mehrere Datenleitungen (DL), die einander kreuzen, um mehrere Pixel (P) zu definieren, wobei die mehreren Gateleitungen (GL) eine erste Gateleitung (1GL), an die ein Scansignal (SC) angelegt wird, und eine zweite Gateleitung (2GL), an die ein Scanstromsignal (SPO) angelegt wird, aufweisen und die mehreren Datenleitungen (DL) eine Datenleitung, die dazu ausgelegt ist, eine Datenspannung zu empfangen, aufweist; wobei die Anzeigevorrichtung ferner umfasst
eine Referenzleitung (Ref), an die eine Referenzspannung (Vref) angelegt wird;
wobei ein Pixel (P) aufweist:
eine OLED und eine Pixelansteuerungsschaltung (C) zur unabhängigen Ansteuerung der OLED des Pixels (P), wobei die Pixelansteuerungsschaltung (C) zur Ansteuerung der OLED mit der Datenleitung (DL), der Referenzleitung (Ref) und der ersten und der zweite Gateleitung (1GL, 2GL) verbunden ist;
wobei die Pixelansteuerungsschaltung (C) einen ersten Schalt-TFT (SW1), einen zweiten Schalt-TFT (SW2), einen Speicherkondensator (Cst) und einen Ansteuerungs-TFT (DT) umfasst,
wobei der erste Schalt-TFT (SW1) basierend auf dem Scansignal (SC) eingeschaltet wird, um die Datenspannung an eine erste Elektrode des Speicherkondensators (Cst) bereitzustellen,
wobei der zweite Schalt-TFT (SW2) eines P-Typs basierend auf einem Scanimpuls (SP) des Scanstromsignals (SPO) eingeschaltet wird, um die Referenzspannung (Vref) an eine zweite Elektrode des Speicherkondensators (Cst) bereitzustellen, wobei das Scanstromsignal (SPO) den Scanimpuls (SP), der einer Gate-An-Spannung für den zweiten Schalt-TFT (SW2) entspricht, und eine Versorgungsspannung, die einer Gate-Aus-Spannung für den zweiten Schalt-TFT (SW2) entspricht, umfasst,
wobei der Speicherkondensator (Cst) zum Laden einer Differenzspannung zwischen der Datenspannung und der Referenzspannung (Vref) und zum Bereitstellen der Differenzspannung an den Ansteuerungs-TFT (DT) dient; und
wobei der Ansteuerungs-TFT (DT) zum Bereitstellen der Versorgungsspannung an die OLED basierend auf der Differenzspannung dient, um einen Strom zu steuern, der an die OLED bereitzustellen ist;
wobei eine Gateelektrode, eine erste Elektrode und eine zweite Elektrode des ersten Schalt-TFT (SW1) mit der ersten Gateleitung (1GL), der Datenleitung (DL) bzw. einem ersten Knoten (n1) verbunden sind,
wobei eine Gateelektrode, eine erste Elektrode und eine zweite Elektrode des zweiten Schalt-TFT (SW2) mit der zweiten Gateleitung (GL2), der Referenzleitung (Ref) bzw. einem zweiten Knoten (n2) verbunden sind,
wobei eine Gateelektrode, eine erste Elektrode und eine zweite Elektrode des Ansteuerungs-TFT (DT) mit dem ersten Knoten (n1), der zweiten Gateleitung (2GL) und dem zweiten Knoten (n2) verbunden sind,
wobei der Speicherkondensator (Cst) zwischen dem ersten Knoten (n1) und dem zweiten Knoten (n2) verbunden ist;
wobei die OLED eine Anode hat, die mit dem zweiten Knoten (n2) verbunden ist, und eine Kathode, die mit einer Niedrigpotential-Stromleitung (Vss) verbunden ist.

2. OLED-Anzeigevorrichtung nach Anspruch 1, wobei der Scanimpuls (SP) eine negative (-) Spannung ist und die Versorgungsspannung eine positive (+) Spannung ist.

3. OLED-Anzeigevorrichtung nach einem der vorhergehenden Ansprüche, wobei die zweite Gateleitung (2GL) eine einzelne Leitung ist, an die das Scanstromsignal (SPO) angelegt wird, das den Scanimpuls (SP), der einer Gate-An-Spannung für den zweiten Schalt-TFT (SW2) entspricht, und die Versorgungsspannung, die einer Gate-Aus-Spannung für den zweiten Schalt-TFT (SW2) entspricht, umfasst.

4. Anzeigevorrichtung mit organischen lichtemittierenden Dioden, OLED, umfassend:
mehrere Gateleitungen (GL) und mehrere Datenleitungen (DL), die einander kreuzen, um mehrere Pixel (P) zu definieren, wobei die mehreren Gateleitungen (GL) eine erste Gateleitung (1GL), an die ein Scansignal (SC) angelegt wird und eine zweite Gateleitung (2GL), an die ein Scanstromsignal (SPO) angelegt wird, aufweisen und die mehreren Datenleitungen (DL) eine Datenleitung, die dazu ausgelegt ist, eine Datenspannung zu empfangen, aufweisen; wobei die Anzeigevorrichtung ferner umfasst:
eine Initialisierungsleitung (IN), an die eine Initialisierungsspannung Vini angelegt wird;
eine Emissionssteuerungsleitung (EM), an die ein Emissionssteuerungssignal angelegt wird;
wobei ein Pixel (P) aufweist:
eine OLED und eine Pixelansteuerungsschaltung (C) zur unabhängigen Ansteuerung der OLED des Pixels (P), wobei die Pixelansteuerungsschaltung (C) zur Ansteuerung der OLED mit der Datenleitung (DL), der Initialisierungsleitung (IN), der Emissionssteuerungsleitung (EM) und der ersten und der zweiten Gateleitung (GL1, GL2) verbunden ist,
wobei die Pixelansteuerungsschaltung (C) einen ersten Schalt-TFT (SW1), einen zweiten Schalt-TFT (SW2), einen dritten Schalt-TFT (SW3), einen Speicherkondensator (Cst) und einen Ansteuerungs-TFT (DT) umfasst,
wobei der erste Schalt-TFT (SW1) basierend auf dem Scansignal (SC) eingeschaltet wird, um die Datenspannung an eine erste Elektrode eines Speicherkondensators (Cst) bereitzustellen;
der zweite Schalt-TFT (SW2) eines P-Typs basierend auf einem Scanimpuls (SP) des Scanstromsignals (SPO) eingeschaltet wird, um die Initialisierungsspannung (Vini) an eine zweite Elektrode des Speicherkondensators bereitzustellen, das Scanstromsignal (SPO) den Scanimpuls (SP), der einer Gate-An-Spannung für den zweiten Schalt-TFT (SW2) entspricht, und eine Versorgungsspannung, die einer Gate-Aus-Spannung für den zweiten Schalt-TFT (SW2) entspricht, umfasst;
wobei der dritte Schalt-TFT (SW3) basierend auf dem Emissionssteuersignal eingeschaltet wird, um die Versorgungsspannung an den Ansteuerungs-TFT (DT) bereitzustellen;
wobei der Speicherkondensator (Cst) zum Laden einer Differenzspannung zwischen der Initialisierungsspannung (Vini) und einer Spannung, die durch Kompensieren einer Schwellenspannung des Ansteuerungs-TFT (DT) in der Datenspannung erhalten wird, und zum Bereitstellen der Differenzspannung an den Ansteuerungs-TFT (DT) dient; und
wobei der Ansteuerungs-TFT (DT) zum Bereitstellen der Versorgungsspannung an die OLED basierend auf der Differenzspannung, um einen Strom zu steuern, der an die OLED bereitzustellen ist, dient;
wobei eine Gate-Elektrode, eine erste Elektrode und eine zweite Elektrode des ersten Schalt-TFT (SW1) mit der ersten Gateleitung (1GL), der Datenleitung (DL) bzw. einem ersten Knoten (n1) verbunden sind,
wobei eine Gateelektrode, eine erste Elektrode und eine zweite Elektrode des zweiten Schalt-TFT (SW2) mit der zweiten Gateleitung (GL2), der Initialisierungsleitung (IN) bzw. einem zweiten Knoten (n2) verbunden sind,
wobei eine Gateelektrode, eine erste Elektrode und eine zweite Elektrode des dritten Schalt-TFT (SW3) mit der Emissionsleitung (EM), der zweiten Gateleitung (2GL) bzw. einer ersten Elektrode des Ansteuerungstransistors (DT) verbunden sind,
wobei eine Gate-Elektrode, die erste Elektrode und eine zweite Elektrode des Ansteuerungs-TFT (DT) mit dem ersten Knoten (n1), der zweiten Elektrode des dritten Schalt-TFT (SW3) (2GL) bzw. dem zweiten Knoten (n2) verbunden sind, und
wobei der Speicherkondensator (Cst) zwischen dem ersten Knoten (n1) und dem zweiten Knoten (n2) verbunden ist; und
wobei die OLED eine Anode hat, die mit dem zweiten Knoten (n2) verbunden ist, und eine Kathode, die mit einer Niedrigpotential-Stromleitung (Vss) verbunden ist.

5. OLED-Anzeigevorrichtung nach Anspruch 4, wobei zwei benachbarte Pixel (P) die Initialisierungsleitung (IN) gemeinsam nutzen.

6. OLED-Anzeigevorrichtung nach Anspruch 4 oder 5, wobei die Pixelansteuerungsschaltung (C) ferner einen Hilfskondensator (Cc) umfasst, der zwischen dem ersten Knoten (n1) und der zweiten Gateleitung (GL2) verbunden ist.

7. OLED-Anzeigevorrichtung nach einem der Ansprüche 4 bis 6, wobei der Scanimpuls (SP) in einer ersten Periode (a) des Scanstromsignals (SPO) angelegt wird und die Versorgungsspannung in einer zweiten Periode (b) des Scanstromsignals (SPO) angelegt wird, und eine Gate-Aus-Spannung (Vaus) des Scanstromsignals (SPO) in einer dritten Periode (c) angelegt wird.

8. OLED-Anzeigevorrichtung nach einem der Ansprüche 4 bis 7, wobei der Scanimpuls (SP) eine negative (-) Spannung ist und die Versorgungsspannung eine positive (+) Spannung ist.

9. OLED-Anzeigevorrichtung nach einem der vorhergehenden Ansprüche, wobei die Versorgungsspannung eine Hochpotential-Versorgungsspannung zur Ansteuerung der OLED ist.

10. OLED-Anzeigevorrichtung nach einem der vorhergehenden Ansprüche, wobei der Scanimpuls (SP) in einer Auswahlperiode (SE1) angelegt wird und die Versorgungsspannung zur Ansteuerung der OLED während der Emissionsperiode (E1) dient.

11. Verfahren zur Ansteuerung der Anzeigevorrichtung mit organischen lichtemittierenden Dioden (OLED) nach Anspruch 1, umfassend die Schritte:
Zuführen des Scanimpulses (SP) über die zweite Gateleitung (2GL) zu dem zweiten Schalt-TFT (SW2) während einer Nichtemissionsperiode (1) zum Einschalten des zweiten Schalt-TFT (SW2);
Zuführen der Versorgungsspannung über dieselbe zweite Gateleitung (2GL) zu dem Ansteuerungs-TFT (DT) der OLED während einer Emissionsperiode (2, 3), wobei die Versorgungsspannung einer Gate-Aus-Spannung des zweiten Schalt-TFT (SW2) entspricht.

12. Verfahren zur Ansteuerung der Anzeigevorrichtung mit organischen lichtemittierenden Dioden (OLED) nach Anspruch 4, umfassend die Schritte:
Zuführen des Scansignals (SC) über die erste Gateleitung (1GL) zu dem ersten Schalt-TFT (SW1) und Zuführen einer negativen Gate-An-Spannung des Scanstromsignals (SPO) über die zweite Gateleitung (2GL) zu einem zweiten Schalt-TFT (SW2) und über die Emissionssteuerungsleitung (EM) zu dem dritten Schalt-TFT (SW3) in einer Initialisierungsperiode (a);
Halten des Scansignals (SC) über die erste Gateleitung (1GL) zu dem ersten Schalt-TFT (SW1) und Zuführen der Versorgungsspannung über dieselbe zweite Gateleitung (2GL) und über dieselbe Emissionssteuerleitung (EM) in einer Abtastperiode (b),
Halten des Scansignals (SC) über die erste Gateleitung (1 GL) zu dem ersten Schalt-TFT (SW1) und Zuführen einer Gate-Aus-Spannung (Vaus) über dieselbe zweite Gateleitung (2GL) und über dieselbe Emissionssteuerleitung (EM) in einer Ladeperiode (c),
Zuführen der Gate-Aus-Spannung (Vaus) über die erste Gateleitung (1GL) zu dem ersten Schalt-TFT (SW1) und Zuführen der Versorgungsspannung über dieselbe zweite Gateleitung (2GL) und über dieselbe Emissionssteuerungsleitung (EM) in einer Emissionsperiode (d).

## Revendications

1. Dispositif d'affichage à diodes électroluminescentes organiques, OLED, comprenant :
une pluralité de lignes de grille (GL) et une pluralité de lignes de données (DL) en intersection entre elles pour définir une pluralité de pixels (P), dans lequel la pluralité de lignes de grille (GL) inclut une première ligne de grille (1GL) à laquelle un signal de balayage (SC) est appliqué et une deuxième ligne de grille (2GL) à laquelle un signal de puissance de balayage (SPO) est appliqué, et la pluralité de lignes de données (DL) inclut une ligne de données apte à recevoir une tension de données ; dans lequel le dispositif d'affichage comprend en outre :
une ligne de référence (Ref) à laquelle une tension de référence (Vref) est appliquée ;
dans lequel un pixel (P) inclut :
une OLED et un circuit d'attaque de pixel (C) pour l'attaque indépendante de l'OLED du pixel (P), dans lequel le circuit d'attaque de pixel (C) est relié à la ligne de données (DL), à la ligne de référence (Ref), et aux première et deuxième lignes de grille (1GL, 2GL) pour l'attaque de l'OLED ;
dans lequel le circuit d'attaque de pixel (C) comprend un premier TFT de commutation (SW1), un deuxième TFT de commutation (SW2), un condensateur de stockage (Cst), et un TFT d'attaque (DT),
dans lequel le premier TFT de commutation (SW1) est activé sur la base du signal de balayage (SC) pour fournir la tension de données à une première électrode du condensateur de stockage (Cst),
dans lequel le deuxième TFT de commutation (SW2) d'un type P est activé sur la base d'une impulsion de balayage (SP) du signal de puissance de balayage (SPO) pour fournir la tension de référence (Vref) à une deuxième électrode du condensateur de stockage (Cst), le signal de puissance de balayage (SPO) comprenant l'impulsion de balayage (SP) correspondant à une tension d'activation de grille pour le deuxième TFT de commutation (SW2) et une tension de puissance correspondant à une tension de désactivation de grille pour le deuxième TFT de commutation (SW2),
dans lequel le condensateur de stockage (Cst) est destiné à charger une tension de différence entre la tension de données et la tension de référence (Vref) et pour fournir la tension de différence au TFT d'attaque (DT) ; et
dans lequel le TFT d'attaque (DT) est destiné à fournir la tension de puissance à l'OLED sur la base de la tension de différence pour commander un courant à fournir à l'OLED ;
dans lequel une électrode de grille, une première électrode, et une deuxième électrode du premier TFT de commutation (SW1) sont reliées respectivement à la première ligne de grille (1GL), à la ligne de données (DL) et à un premier noeud (n1),
dans lequel une électrode de grille, une première électrode et une deuxième électrode du deuxième TFT de commutation (SW2) sont reliées respectivement à la deuxième ligne de grille (GL2), à la ligne de référence (Ref) et à un deuxième noeud (n2),
dans lequel une électrode de grille, une première électrode, et une deuxième électrode du TFT d'attaque (DT) sont reliées respectivement au premier noeud (n1), à la deuxième ligne de grille (2GL) et au deuxième noeud (n2), et
dans lequel le condensateur de stockage (Cst) est relié entre le premier noeud (n1) et le deuxième noeud (n2) ;
dans lequel l'OLED comporte une anode reliée au deuxième noeud (n2) et une cathode reliée à une ligne de puissance à bas potentiel (Vss).

2. Dispositif d'affichage OLED selon la revendication 1, dans lequel l'impulsion de balayage (SP) est une tension négative (-), et la tension de puissance est une tension positive (+).

3. Dispositif d'affichage OLED selon l'une quelconque des revendications précédentes, dans lequel la deuxième ligne de grille (2GL) est une ligne unique à laquelle est appliqué le signal de puissance de balayage (SPO) comprenant l'impulsion de balayage (SP) correspondant à une tension d'activation de grille pour le deuxième TFT de commutation (SW2) et la tension de puissance correspondant à une tension de désactivation de grille pour le deuxième TFT de commutation (SW2).

4. Dispositif d'affichage à diodes électroluminescentes organiques, OLED, comprenant :
une pluralité de lignes de grille (GL) et une pluralité de lignes de données (DL) en intersection entre elles pour définir une pluralité de pixels (P), dans lequel la pluralité de lignes de grille (GL) inclut une première ligne de grille (1GL) à laquelle un signal de balayage (SC) est appliqué et une deuxième ligne de grille (2GL) à laquelle un signal de puissance de balayage (SPO) est appliqué, et la pluralité de lignes de données (DL) inclut une ligne de données apte à recevoir une tension de données ; dans lequel le dispositif d'affichage comprend en outre :
une ligne d'initialisation (IN) à laquelle une tension d'initialisation (Vini) est appliquée ;
une ligne de commande d'émission (EM) à laquelle un signal de commande d'émission est appliqué ;
dans lequel un pixel (P) inclut :
une OLED et un circuit d'attaque de pixel (C) pour l'attaque indépendante de l'OLED du pixel (P), dans lequel
le circuit d'attaque de pixel (C) est relié à la ligne de données (DL), à la ligne d'initialisation (IN), à la ligne de commande d'émission (EM), et aux première et deuxième lignes de grille (1GL, 2GL) pour l'attaque de l'OLED,
dans lequel le circuit d'attaque de pixel (C) comprend un premier TFT de commutation (SW1), un deuxième TFT de commutation (SW2), un troisième TFT de commutation (SW3), un condensateur de stockage (Cst), et un TFT d'attaque (DT),
dans lequel le premier TFT de commutation (SW1) est activé sur la base du signal de balayage (SC) pour fournir la tension de données à une première électrode d'un condensateur de stockage (Cst) ;
le deuxième TFT de commutation (SW2) d'un type P est activé sur la base d'une impulsion de balayage (SP) du signal de puissance de balayage (SPO) pour fournir la tension d'initialisation (Vini) à une deuxième électrode du condensateur de stockage, le signal de puissance de balayage (SPO) comprenant l'impulsion de balayage (SP) correspondant à une tension d'activation de grille pour le deuxième TFT de commutation (SW2) et une tension de puissance correspondant à une tension de désactivation de grille pour le deuxième TFT de commutation (SW2) ;
dans lequel le troisième TFT de commutation (SW3) est activé sur la base du signal de commande d'émission pour fournir la tension de puissance au TFT d'attaque (DT) ;
dans lequel le condensateur de stockage (Cst) est destiné à charger une tension de différence entre la tension d'initialisation (Vini) et une tension obtenue par la compensation d'une tension de seuil du TFT d'attaque (DT) dans la tension de données et pour fournir la tension de différence au TFT d'attaque (DT) ; et
dans lequel le TFT d'attaque (DT) est destiné à fournir la tension de puissance à l'OLED sur la base de la tension de différence pour commander un courant à fournir à l'OLED ;
dans lequel une électrode de grille, une première électrode, et une deuxième électrode du premier TFT de commutation (SW1) sont reliées respectivement à la première ligne de grille (1GL), à la ligne de données (DL) et à un premier noeud (n1),
dans lequel une électrode de grille, une première électrode et une deuxième électrode du deuxième TFT de commutation (SW2) sont reliées respectivement à la deuxième ligne de grille (GL2), à la ligne d'initialisation (IN) et à un deuxième noeud (n2),
dans lequel une électrode de grille, une première électrode, et une deuxième électrode du troisième TFT de commutation (SW3) sont reliées respectivement à la ligne d'émission (EM), à la deuxième ligne de grille (2GL) et à une première électrode du transistor d'attaque (DT),
dans lequel une électrode de grille, une première électrode, et une deuxième électrode du TFT d'attaque (DT) sont reliées respectivement au premier noeud (n1), à la deuxième électrode du troisième TFT de commutation (SW3) et au deuxième noeud (n2), et
dans lequel le condensateur de stockage (Cst) est relié entre le premier noeud (n1) et le deuxième noeud (n2) ; et
dans lequel l'OLED comporte une anode reliée au deuxième noeud (n2) et une cathode reliée à une ligne de puissance à bas potentiel (Vss).

5. Dispositif d'affichage OLED selon la revendication 4, dans lequel deux pixels (P) voisins partagent la ligne d'initialisation (IN).

6. Dispositif d'affichage OLED selon la revendication 4 ou 5, dans lequel le circuit d'attaque de pixel (C) comprend en outre un condensateur auxiliaire (Cc) relié entre le premier noeud (n1) et la deuxième ligne de grille (GL2).

7. Dispositif d'affichage OLED selon l'une quelconque des revendications 4 à 6, dans lequel l'impulsion de balayage (SP) est appliquée dans une première période (a) du signal de puissance de balayage (SPO), la tension de puissance est appliquée dans une deuxième période (b) du signal de puissance de balayage (SPO), et une tension de désactivation de grille (Voff) est appliquée dans une troisième période (c) du signal de puissance de balayage (SPO).

8. Dispositif d'affichage OLED selon l'une quelconque des revendications 4 à 7, dans lequel l'impulsion de balayage (SP) est une tension négative (-), et la tension de puissance est une tension positive (+).

9. Dispositif d'affichage OLED selon l'une quelconque des revendications précédentes, dans lequel la tension de puissance est une tension de puissance à haut potentiel pour l'attaque de l'OLED.

10. Dispositif d'affichage OLED selon l'une quelconque des revendications précédentes, dans lequel l'impulsion de balayage (SP) est appliquée dans une période de sélection (SE1) et la tension de puissance est destinée à l'attaque de l'OLED pendant la période d'émission (E1).

11. Procédé d'attaque du dispositif d'affichage à diodes électroluminescentes, OLED, selon la revendication 1, comprenant les étapes de :
la fourniture de l'impulsion de balayage (SP) par l'intermédiaire de la deuxième ligne de grille (2GL) au deuxième TFT de commutation (SW2) pendant une période de non-émission (1) pour une commutation sur le deuxième TFT de commutation (SW2) ;
la fourniture de la tension de puissance par l'intermédiaire de la même deuxième ligne de grille (2GL) au TFT d'attaque (DT) de l'OLED pendant une période d'émission (2, 3), la tension de puissance correspondant à une tension de désactivation de grille du deuxième TFT de commutation (SW2).

12. Procédé d'attaque du dispositif d'affichage à diodes électroluminescentes, OLED, selon la revendication 4, comprenant les étapes de :
la fourniture du signal de balayage (SC) par l'intermédiaire de la première ligne de grille (1GL) au premier TFT de commutation (SW1) et la fourniture d'une tension d'activation de grille négative du signal de puissance de balayage (SPO) par l'intermédiaire de la deuxième ligne de grille (2GL) au deuxième TFT de commutation (SW2) et par l'intermédiaire de la ligne de commande d'émission (EM) au troisième TFT de commutation (SW3) dans une période d'initialisation (a) ;
le maintien du signal de balayage (SC) par l'intermédiaire de la première ligne de grille (1GL) au premier TFT de commutation (SW1) et la fourniture de la tension de puissance par l'intermédiaire de la même deuxième ligne de grille (2GL) et par l'intermédiaire de la même ligne de commande d'émission (EM) dans une période d'échantillonnage (b) ;
le maintien du signal de balayage (SC) par l'intermédiaire de la première ligne de grille (1GL) au premier TFT de commutation (SW1) et la fourniture d'une tension de désactivation de grille (Voff) par l'intermédiaire de la même deuxième ligne de grille (2GL) et par l'intermédiaire de la même ligne de commande d'émission (EM) dans une période de charge (c) ;
la fourniture de la tension de désactivation de grille (Voff) par l'intermédiaire de la première ligne de grille (1GL) au premier TFT de commutation (SW1) et la fourniture de la tension de puissance par l'intermédiaire de la même deuxième ligne de grille (2GL) et par l'intermédiaire de la même ligne de commande d'émission (EM) dans une période d'émission (d) .
